Europäisches Patentamt

(19) European Patent Office

Office européen des brevets

(11) **EP 0 897 124 A1**

(12) **EUROPEAN PATENT APPLICATION**

(43) Date of publication:
**17.02.1999 Bulletin 1999/07**

(21) Application number: **98202691.6**

(22) Date of filing: **11.08.1998**

(51) Int. Cl.$^6$: **G02B 6/293**, G02B 6/124,
G02B 6/34, H01S 3/06,
H01S 3/085

(84) Designated Contracting States:
**AT BE CH CY DE DK ES FI FR GB GR IE IT LI LU
MC NL PT SE**
Designated Extension States:
**AL LT LV MK RO SI**

(30) Priority: **12.08.1997 US 55242 P
06.02.1998 US 19985**

(71) Applicant:
**Photonics Research Ontario
Toronto, Ontario M5S 1A7 (CA)**

(72) Inventor: **Gu, Xijia
North York, Ontario M3A 2G3 (CA)**

(74) Representative:
**Frei, Alexandra Sarah
Frei Patentanwaltsbüro
Postfach 768
8029 Zürich (CH)**

(54) **Design of complex optical fiber filters using long-period gratings**

(57)     Optical fiber transmission filters and methods of producing the filters with preselected transmission spectra are disclosed. The transmission filters include a long-period grating (LPG) having a first grating section and a second grating section spaced from the first section by a phase gap. The presence of a phase gap in the LPG introduces a phase shift wherein the amplitude of the electromagnetic radiation passing through the first section adds vectorially to the amplitude of the light passing through the second section with an angle $\phi$ related to the phase gap. When the gap length $\Delta$ equals to a half grating period a ($a=\Lambda/2$), a $\pi$ phase shift is introduced between the light transmitted through the two parts. By carefully selecting the length $L_1$, the period of the two sections and the gap $\Delta$ to give a preselected phase shift, the transmission loss peak can be designed to meet preselected specifications. Transmission filters for gain flattening of erbium-doped fiber amplifiers, notch filters, filters for suppression of amplified spontaneous emission and the like have been produced. Also disclosed are filters including chirped cascaded long-period gratings that exhibit multiple loss peaks over a wavelength band as broad as 240 nm.

FIGURE 3

EP 0 897 124 A1

## Description

## FIELD OF THE INVENTION

The present invention relates to optical filters and more particularly the invention relates to optical waveguide transmission filters using long-period fiber gratings.

## BACKGROUND OF THE INVENTION

Many optical fiber communication systems using optical devices require spectrally selective filters. Particularly, wavelength-dependent loss elements are used as filters to modify the transmission spectra in the systems. Examples of systems requiring spectrally selective filters include gain flattening of Er-doped fiber amplifiers (EDFA), band-rejection filters in cascaded Raman lasers for removing unnecessary Stoke's orders and spectral shaping for high-power broadband sources and suppression of amplified spontaneous emission (ASE) to mention just a few. To satisfy the challenging demands of these various applications, the optical fiber filter should provide customer-specified transmission characteristics such as depth, width and most importantly the spectral shape of loss peak.

One type of wavelength-dependent loss element, the so called Bragg grating, also referred to as short-period grating, comprises an optical fiber having a periodic refractive index modulation along a portion of the fiber with a periodicity of the order of .5 $\mu$m. The Bragg grating couples the forward guided mode into a backward guided mode and is therefore commonly referred to as a reflective filter. United States Patent No. 4,474,427 issued to Hill is directed to a Bragg grating filter and a method of producing the filter. The method of producing the reflective filter involves transmitting a light beam of suitable frequency and intensity through the fiber and reflecting the beam back through the fiber to set up an interference pattern which results in permanent refractive index modulation along the fiber. United States Patent No. 5,367,588 issued to Hill discloses a method of fabricating Bragg gratings using a silica glass phase grating mask that requires a phase mask and a coherent laser beam to fabricate gratings. The use of Bragg gratings as band-rejection filters in cascaded fiber Raman lasers is disclosed in S.G. Grubb and A.J. Stentz, "**Fiber Raman Lasers Emit At Many Wavelengths**", Laser Focus World, Feb. p 127, (1996).

Drawbacks associated with Bragg gratings include the fact that they cannot readily be used for all of the above applications. For example, the strong back-reflection of Bragg gratings may interfere with the preceding system. It is difficult to obtain a band width of more than several nanometers from a Bragg grating. Low back-reflection is necessary in several applications which necessitate accurate control over the tilt angle of the blazed grating.

Another type of wavelength-dependent loss element is the long-period grating (LPG). Long-period gratings comprise an optical fiber with refractive index perturbations having a periodicity $\Lambda$ in the range of about 10 $\mu$m $\leq \Lambda \leq$ 2000 $\mu$m. The long period gratings filter unwanted wavelengths by coupling them into non-guided modes through the cladding surrounding the fiber core. In this regard a long-period grating is a transmission filter with little or no reflection.

The LPGs are fabricated by inducing large refractive index modulation along the fiber axis in photosensitive germanosilicate fibers by irradiating the fiber core with ultraviolet (UV) light. As mentioned above, the LPGs couple light from a guided mode into forward-propagating cladding modes so that several loss peaks will appear in the grating transmission spectrum due to absorption and scattering of the light in cladding modes. The wavelengths of the loss peaks are determined by the grating period and the difference of the refractive index between guided modes and the cladding modes. The width of the loss peaks are determined by the peak wavelength, the grating length and the difference of the effective refractive index between the guided mode and the cladding mode. Several applications of long-period fiber gratings have been reported in the above-mentioned optical fiber systems.

Long-period fiber gratings (LPG) have recently emerged as compact, low insertion-loss, and minimum back reflection in-fiber devices that function as wavelength-dependent loss elements for suppressing amplified spontaneous emission (ASE), see Ashish M. Vengsarkar, Paul J. Lemaire, Justin B. Judkins, Vikram Bhatia, Turan Erdogan and John E. Sipe, "**Long-period Fiber Gratings As Band-Rejection Filter**", Lightwave Technol. Vol. 14, p58, (1996). Long-period gratings have also been used for gain flattening of Er-doped fiber amplifiers as disclosed in Ashish M. Vengsarkar, J. Renee Pedrazzani, Justin B. Judkins and Paul J. Lemaire, "**Long-Period Fiber-Grating-Based Gain Equalizers**", Optics Letters, Vol.21, No.5, p. 336 (1996). C.W. Hodgson and A. M. Vengsarkar, "**Spectrally Shaped High-Power Amplified Spontaneous Emission Sources Incorporating Long-Period Gratings**", OFC'96, Technical Digest, TuG3, p 29, (1996) discloses the use of long-period gratings for spectral shaping for high-power broadband sources.

The use of long-period gratings as spectral shaping devices in an optical fiber communication system has been disclosed in United States Patent No. 5,430,817. In that device, the long-period grating includes a simple periodic refractive index modulation. The transmission spectrum of such a grating is a symmetrical loss peak. This patent also discloses use of short period Bragg reflection gratings for reflecting certain wavelengths into a long period grating structure for constructing a wavelength shift detector.

Two or more long-period gratings have to be concatenated in order to match complex spectral shapes.

An optical semiconductor waveguide resonator filter having a $\pi/2$ phase shift inserted in the middle of two grating sections has been disclosed in U.S. Pat. No. 4,750,801. The transmission spectrum of the resonator filter has a sharp peak with 4 Angstrom bandwidth in a 30 Angstrom wide stopband. In view of the semiconductor nature of these waveguide devices, they are prone to large coupling losses when used in fiber communication systems.

United States Patent No. 4,750,801 issued to Alferness is directed to optical waveguide resonator filters having a semiconductor grating section grown on a semiconductor substrate. The grating section includes two gratings spaced apart and an electrode applied to the top surface of the gap between the two gratings is used to modulate light passing through the filter.

United States Patent No. 5,495,543 issued to Alferness et al. extends the concept of '801 discussed above in that it provides a polarization-independent optical wavelength selective filter and coupler using a double-period grating on a semiconductor waveguide. The double-period grating is essentially a combination of two gratings differing slightly in grating period with the grating period selected to match differences in propagation constants of the TE and TM polarization modes of light transmitted through the filter in order to couple the two modes.

United States Patent No. 5,416,866 issued to Sahlen discloses a tunable optical waveguide filter. A grating structure having two controllable grating sections etched therein is formed in a waveguide structure. Current injection electrodes applied to each section permit independent control of the wavelength tuning range for each of the two grating sections. United States Patent No. 5,647,039 issued to Judkins et al. teaches optical fiber based switching systems using long period gratings. The optical fiber has a long period grating having a plurality of refractive index perturbations of width w separated by a constant periodic distance $\Lambda$. A detector placed on the fiber beside the grating is used to detect wavelengths coupled out of the fiber when the switch is activated.

As mentioned above, one of the major applications of optical fiber filter with complex loss shape is the gain flattening of EDFA. Wavelength-Division Multiplexing (WDM) has been extensively studied in order to achieve high data transmission over optical fibers. WDM channels (each transmitting several gigabits per second) should fit in the 1530-1560 nm band of EDFA. One of the major problems in WDM systems is gain non-uniformity of EDFAs that leads to uneven signal amplitudes in the different channels. One requires a filter with a transmission spectrum which matches to the inverted erbium gain spectrum. For example, for gain flattening of the EDFA over the 1540-1565 nm range requires a filter with a broad loss peak centered at 1557 nm and a shoulder on the shorter wavelength side. However, long-period gratings provide only symmetrical sharp loss peaks. To achieve customer-designed spectral shape, attempts have been made to concatenate two or even three gratings to simulate certain spectral shapes, see Ashish M. Vengsarkar, J. Renee Pedrazzani, Justin B. Judkins and Paul J. Lemaire, "**Long-Period Fiber-Grating-Based Gain Equalizers**", Optics Letters, Vol.21, No.5, p. 336 (1996). The concatenation not only increases the difficulties in the fabrication process, but also makes the packaging more complicated as the gratings would be twice or three times longer. Although Vensarkar's method produces moderate results, one limitation is that a mask having several grating sections is provided and the mask is moved to different locations along the optical fibre to write a particular grating sections to a different regions.

In contrast, the instant invention is concerned with providing a preselected phase gap in advance of irradiating two adjacent regions of the optical waveguide. Hence, the instant invention provides an amplitude mask having a preselected phase gap $\Delta$ between the two adjacent grating sections, thereby providing a large degree of control and accuracy of the phase gap dimension $\Delta$.

To date, there has been no comprehensive method for designing optical waveguide filters with complex transmission spectral shapes such as a Gaussian profiles, a Gaussian with a shoulder on either the shorter or longer wavelength side and a notch filter with a flat bottom. Therefore, it would be very advantageous to provide a method for fabricating optical waveguide filters with transmission spectra of different depths, width and shapes. The waveguide filters so obtained should exhibit low insertion-losses, be compact, readily amenable to mass production, and be easily packaged. Throughout this specification optical fibers have been referred to in specific embodiments, however monolithic blocks having dielectric waveguides therein may be used in place of separate optical fibres.

## SUMMARY OF THE INVENTION

It is an object of the present invention to provide optical fiber transmission filters based on long-period gratings and methods of producing the filters.

Methods of producing optical transmission fiber filters based on long-period gratings are disclosed. Fiber filters exhibiting different transmission spectral shapes such as a Gaussian profile, a Gaussian with a shoulder on either shorter or longer wavelength side, a notch with a flat bottom and multiple loss peaks over a band as broad as 240 nm are disclosed.

In one aspect of the present invention there is provided an optical fiber filter comprising an optical fiber including at least a core and a long-period grating in the core. The long-period grating includes at least two grating sections, a first grating section having a first grating section periodicity and a second grating section having a second grating section periodicity. The first grating section is spaced from the second grating section by a preselected phase gap $\Delta$.

In this aspect of the invention the preselected gap has a width $\Delta$, wherein the at least first and second grating sections have substantially equal periodicities given by $\Lambda$, and wherein $\Delta < \Lambda$.

The present invention provides an optical fiber filter comprising an optical fiber including a long-period fiber grating having a length L and a periodicity $\Lambda$. The long-period grating includes first and second grating sections, the second grating section being spaced from the first grating section by a preselected gap $\Delta$, wherein $\Delta < \Lambda$.

The present invention also provides an optical fiber filter comprising an optical fiber including at least a core and a long-period grating in the core, the long-period grating including a length L and at least two grating sections, a first grating section having a periodicity $\Lambda_1$ and a second grating section having a periodicity $\Lambda_2$, wherein $\Lambda_2 > \Lambda_1$. The second grating section being spaced from the first grating section by a preselected phase gap $\Delta < \Lambda_2$.

In another aspect of the invention there is provided an optical fiber filter for gain flattening of an erbium-doped fiber amplifier comprising an optical fiber including a long-period fiber grating of length L having a grating periodicity $\Lambda$ in a range $10~\mu m \leq \Lambda \leq 2000~\mu m$. The long-period grating includes at least a first grating section of length $L_1$, wherein $L_1/L \leq 0.5$, and a second grating section spaced from the first grating section by a preselected gap of length $\Delta$, wherein $\Delta < \Lambda$.

The present invention also provides an optical fiber notch filter for suppressing amplified spontaneous emissions comprising an optical fiber including at least a long-period grating having a length L. The long-period grating has a grating periodicity $\Lambda$ in a range from about $10~\mu m$ to about $2000~\mu m$. The long-period fiber grating includes at least a first grating section of length $L_1$, and a second grating section spaced from the first grating section by a preselected phase gap of length $\Delta$.

In another aspect of the invention there is provided a multi-wavelength isolation filter comprising an optical fiber including a core and at least two long-period gratings in the core. At least one of the at least two long-period gratings is chirped and the at least two long-period gratings are spaced apart by a preselected distance.
In this aspect of the invention the at least two long-period gratings may include an unchirped long-period grating and a chirped grating spaced from the unchirped grating.

In this aspect of the invention the at least two long-period gratings may two chirped long-period gratings, and wherein the at least two chirped long-period gratings each have a preselected length and a preselected chirp, and wherein the preselected distance is in the range of from about 1 cm to about 80 cm.

The present invention also provides a gain-flattened erbium-doped fiber amplifier comprising an optical fiber including at least an erbium-doped portion and long-period fiber grating of length L located in the erbium doped portion. The long-period grating has a grating periodicity $\Lambda$ in a range $10~\mu m \leq \Lambda \leq 2000~\mu m$ and the long-period grating includes at least a first grating section of length $L_1$, and a second grating section spaced from the first grating section by a preselected gap of length $\Delta$, wherein $\Delta$ <HS2206> $\Lambda$.

It should be noted that preferable results are obtained if the phase shift provided by the phase gap is between approximately 150 degrees and 180 degrees, or said range plus an $n\pi$ shift, where n is an even number. In another aspect of the invention, there is provided, a method of making an optical waveguide filter, comprising the steps of:

providing a dielectric optical waveguide having at least a core, cladding and a photosensitive longitudinal portion;
providing an amplitude mask having at least two sections therein spaced by a preselected phase gap, the preselected phase gap, being selected to provide a desired output response of the optical waveguide filter;
and irradiating the dielectric optical waveguide through the amplitude mask for a time sufficient to effect a long-period grating within said core, the long-period grating including at least two grating sections directly corresponding to the at least two sections within the mask, the long period grating within the core having the preselected phase gap $\Delta$ between the at least two grating sections.

BRIEF DESCRIPTION OF THE DRAWINGS

The optical fiber transmission filters constructed in accordance with the present invention will now be described, by way of example only, reference being had to the accompanying drawings, in which:

Figure 1 illustrates the design of a phase-inserted amplitude mask used for producing the long-period grating based optical fiber filters in accordance with the present invention;
Figure 2 illustrates the energy distribution of a focused Excimer laser beam in horizontal direction used in conjunction with the mask of Figure 1 for producing the optical filters;
Figure 3 illustrates the refractive index modulation produced by the uniform UV laser beam irradiating an optical fiber through the phase-inserted amplitude mask of Figure 1;
Figures 4(a), 4(b), 4(c) and 4(d) illustrate the effects of alignment of excimer laser beam with respect to the amplitude mask, the spectrum in Figure 4(a) was from gratings made when the laser beam and the mask were aligned that the two loss peaks have about same depths, the spectra in Figures 4(b) and 4(c) were from gratings made by moving the UV laser beam to the right (away from the gap) with respect to the mask by 1 and 2 mm respectively, and the spectrum in Figure 4(d) was from gratings made by moving the UV laser beam to the left (towards the gap) with respect to the mask by 1 mm;

Figures 5(a) and 5(b) compare the inverted erbium gain spectrum (Figure 5(a)) with the transmission spectrum of a long-period grating filter made for the gain-flattening (Figure 5(b)) constructed according to the present invention;

Figures 6(a), 6(b) and 6(c) compare the transmission spectra of long-period grating with three different phase gaps, the spectrum shown in Figure 6(a) is obtained from the mask with a phase gap of 180°, spectrum in Figure 6(b) from a phase gap of 190° and the spectrum Figure 6(c) from a phase gap of 170° respectively;

Figures 7(a), 7(b) and 7(c) compare the transmission spectra of long-period gratings with different period in two sections, the spectrum in Figure 7(a) is from a grating with the first period of 460 micrometer and second period of 464 micrometer respectively, the spectrum in Figure 7(b) is from a grating with same period of 464 micrometer for first and second sections, and the spectrum in Figure 7(c) is from a grating with the first period of 468 micrometer and second period of 464 micrometer respectively;

Figure 8 shows a transmission spectrum of a notch filter that suppresses 20 dB of transmitted light over a 6 nm band;

Figure 9(a) illustrates the refractive index modulation of two chirped cascaded long-period gratings separated by a distance d;

Figure 9(b) shows a transmission spectrum of the two chirped cascaded long-period gratings of Figure 9(a); and

Figure 9(c) shows a transmission spectrum for two cascaded non-chirped long-period gratings, each 1 cm in length with a spacing of 20 cm between the two gratings.

## DETAILED DESCRIPTION OF THE INVENTION

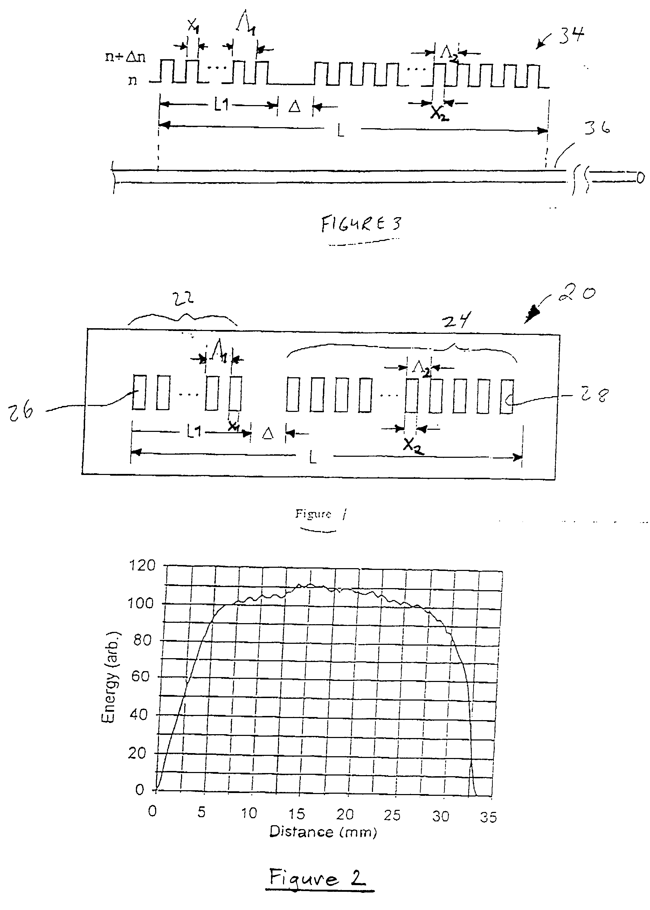

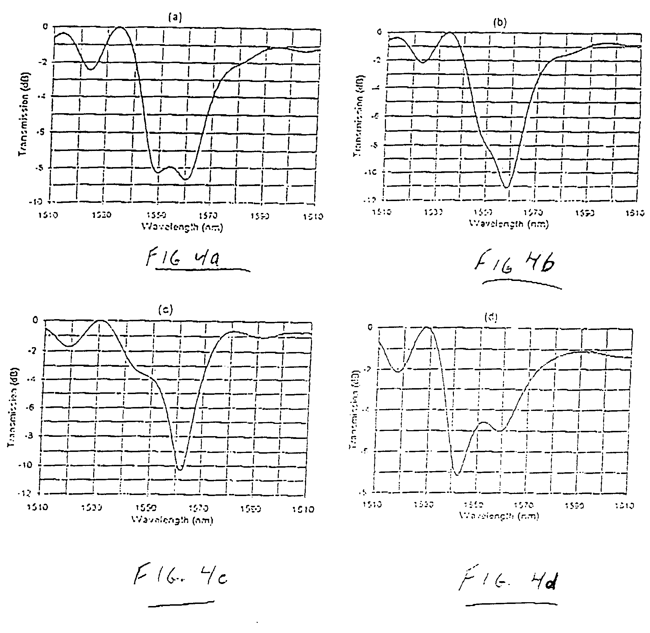

Referring to Figure 1, an amplitude mask for producing long-period gratings in an optical fiber is shown generally at 20. Mask 20 includes two sets of apertures 22 and 24 with set 22 provided with a plurality of spaced apertures 26 and set 24 provided with apertures 28. The first set of apertures 22 span a length $L_1$, has a periodicity of $\Lambda_1$, and each aperture 26 has a width $X_1$. The second set of apertures 24 is shown having a periodicity $\Lambda_2$ and each aperture 28 has a width $X_2$. A gap $\Delta$ separates the two sets of apertures 22 and 24 and the combined length of the both sets of apertures is L.

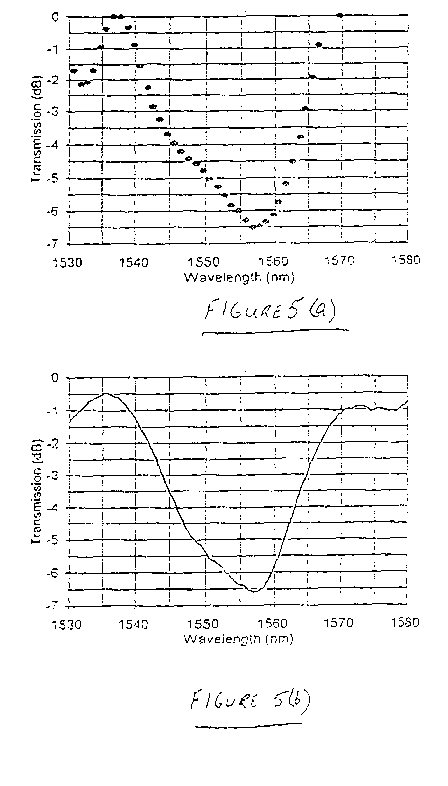

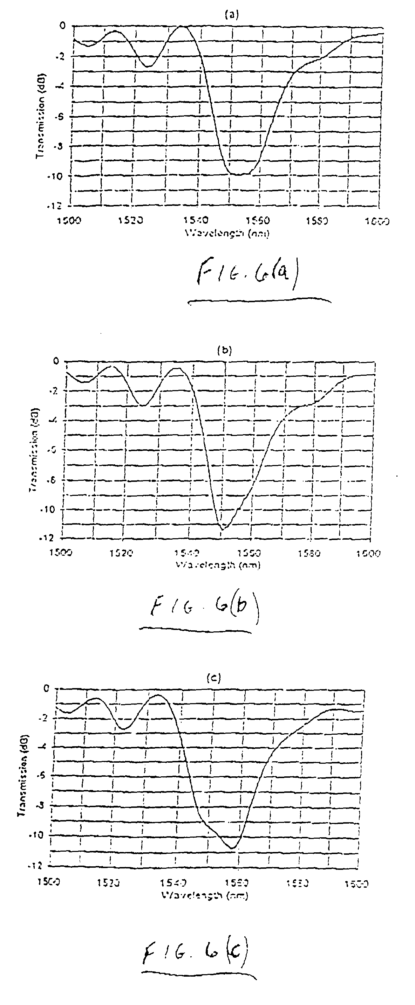

A long-period grating 34 is formed in an optical fiber 36 (Figure 3) by placing amplitude mask 20 (Figure 1) adjacent to a length of the optical fiber 36 and illuminating the fiber with a laser beam (Figure 2) having an appropriate intensity and wavelength to produce the modulation in index of refraction shown in Figure 3. Figure 2 shows the spatial energy distribution of the focussed excimer laser beam in the longitudinal direction used to write in the grating.

The refractive index modulation produced by the uniform UV laser beam irradiating an optical fiber through the phase-inserted amplitude mask of Figure 1 is shown in Figure 3 where n is the refractive index of the core and $\Delta n$ is the increase of the index caused by the UV laser irradiation on a photosensitive optical fiber, $L_1$ is the length of first portion of the grating and includes the half of the period the index is lower at the end of the first portion, L is the overall length of the long-period grating, $\Delta$ is the phase gap, $\Lambda_1$ and $\Lambda_2$ are the periodicities of the two portions of the grating separated by the phase gap, and $X/\Lambda$ is the duty cycle of the modulation in the case when $X=X_1=X_2$.

By introducing a phase gap in the long-period amplitude mask, the LPGs thus made is divided into two grating sections, the first grating section having a length of $L_1$ and the second grating section having a length $L-\Delta-L_1$ respectively as shown in Figure 3. The presence of a phase gap in the LPG introduces a phase shift wherein the amplitude of the electromagnetic radiation passing through the first section adds vectorially to the amplitude of the light passing through the second section with a phase angle $\phi$ between the two vector representations being related to the phase gap. When the gap length $\Delta$ equals to a half grating period a ($a=\Lambda/2$), a $\pi$ phase shift is introduced between the light transmitted through the two parts. The $\pi$ phase gap in the middle of a LPG will split the transmission loss peak into two loss peaks. By moving the $\pi$ phase gap toward the one end of the grating, the two separate peaks will move closer to each other and finally merge into one peak when the $\pi$ phase gap moves to one end of the grating. By carefully selecting the length $L_1$, the periodicity of the two sections and the gap $\Delta$ to give a preselected phase shift, the transmission loss peak can be designed to meet preselected specifications. The phase gap between the two portions of the long-period grating is chosen to be less than the period of the grating since if it is equal to the grating periodicity there will be no effect, or, put another way a phase gap precisely equal to the grating periodicity would give a 360° phase shift. A phase gap in the range $m\Lambda < \Delta < n\Lambda$ (m= 0, 1, 2, 3, ... , n=m+1 ) is also anticipated to produce similar results based on the assumption that the scattering and absorption losses in the phase gap are negligible.

The energy distribution of the UV light source may also influence the shape of loss peak. The excimer laser irradiation, normally used for LPG fabrication, possesses a near-Gaussian distribution as shown in Figure 2. By changing the relative position between LPG mask and excimer laser irradiation the shape of the loss peak can be modified. The inventor contemplates that optical fibers with more than two long-period gratings may also provide useful optical filter devices.

The following examples of optical fiber filters produced using long-period gratings comprising a phase gap between portions of the grating are meant to illustrate the method of the present invention and it will be understood that they are not to be interpreted as limiting the scope of the present invention.

## EXAMPLE 1

### Design And Fabrication Of Long-Period Fiber Gratings For Gain Flattening Of EDFA

An amplitude mask similar to mask 20 in Figure 1 was used to fabricate an LPG with a transmission loss spectrum substantially matched to the inverted erbium gain spectrum. More particularly, a 35 mm mask was provided having two sections separated by a phase gap of 235 micrometers with each section having a periodicity of 470 micrometers. The ratio of $L_1/L$ was approximately 0.21. The rectangular apertures 26 and 28 (Figure 1) had the same dimensions, each rectangular aperture being approximately 1mm in height and 235 micrometers wide. A photosensitive single mode fiber was aligned longitudinally therewith right behind the mask. A KrF excimer laser (Model PM - 844, Lumonics Inc.), lasing at 248 nm irradiated the mask at a repetition rate between 20 to 30 Hz. The energy density of the irradiation was about 200 mJ/cm$^2$ per pulse. The transmission spectrum of the LPG was monitored by an optical spectrum analyzer as the grating was being written. Annealing the fibers once the LPG has been written into the optical fiber may also affect the spectral shape that would be compensated in the design and fabrication process. Therefore, monitoring the transmission spectrum during or after annealing may be required in order to ensure the desired transmission spectrum has been obtained. However, when mass producing the filters, once the effect of annealing an LPG with a preselected transmission spectrum has been established on one or a few test samples, monitoring of all optical fiber filters with the desired LPG and annealed under the same conditions would not be required. In other words, once the effect of annealing an LPG with a given length, periodicity and phase gap is known, the fibers can be produced in quantity without the need for monitoring each fiber being produced.

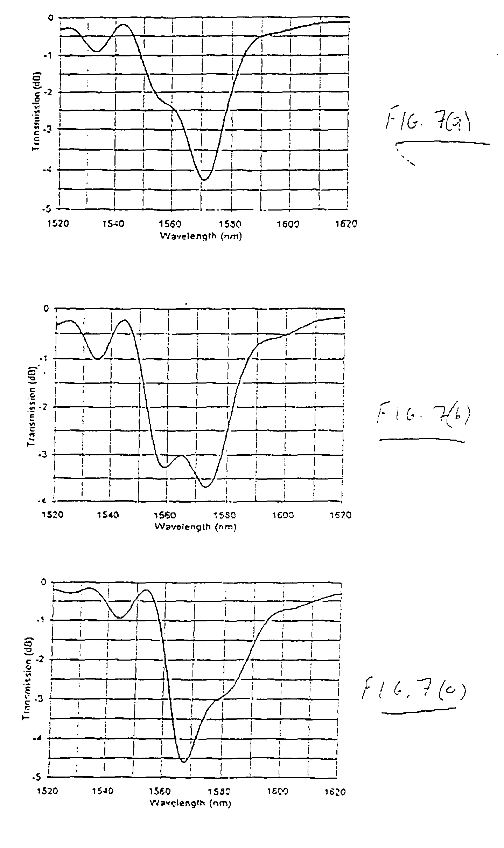

The fibers were irradiated for 2 to 6 minutes depending on the depth of loss peaks and were subsequently annealed at 120 °C for 36 hours. Figures 4(a) to 4(d) show the transmission spectra of LPGs made with the amplitude mask shown in Figure 1. The spectrum in Figure 4(a) exhibits two loss peaks of about 8 dB at 1549 and 1561 nm respectively. Referring to Figures 1 to 3, the spectra in Figures 4(b) and 4(c) were produced from long-period gratings made by moving the UV laser beam (Figure 2) to the right (away from the phase gap Δ) with respect to the mask 20 in Figure 1 by 1 and 2 mm respectively. This resulted in the shifts of the 1549 nm loss peak in spectrum Figure 4(a) towards the shorter wavelengths forming a shoulder. The spectrum in Figure 4(d) was produced using the same grating by moving the UV laser beam to the left (towards the phase gap) with respect to the mask 20 by 1 mm that resulted the reduction of the 1561 nm loss peak in spectrum Figure 4(a) forming a shoulder on the longer wavelength side of the main loss peak. Thus a shoulder can be created and controlled by the lateral positioning of the UV laser beam with respect to the mask. The depth of main loss peak can be controlled by laser irradiation time. Moving the illuminating laser beam off centre to the left or right during the process of writing in the LPG serves to break the uniformity in the modulation of the index of refraction so that the modulation Δn is a function of position in the LPG.

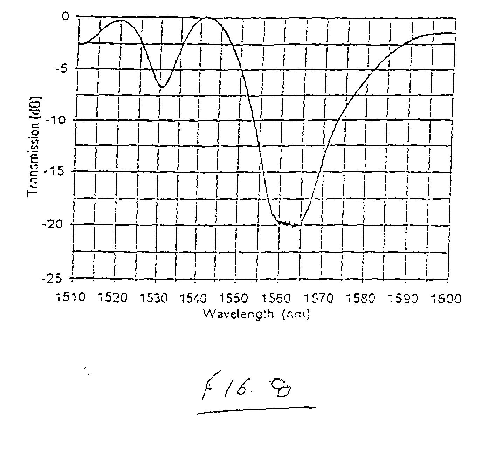

Figure 5(a) shows the inverted erbium gain spectrum. Figure 5(b) shows a transmission spectrum of a long-period grating, made with a mask similar to the mask shown in Figure 1, that matches the inverted erbium gain spectrum. By adjusting the relative position of the illuminating laser beam with respect to the mask and controlling the laser irradiation time, the LPG can give a flat gain spectrum with less than 0.4 dB variation over 25 nm band.

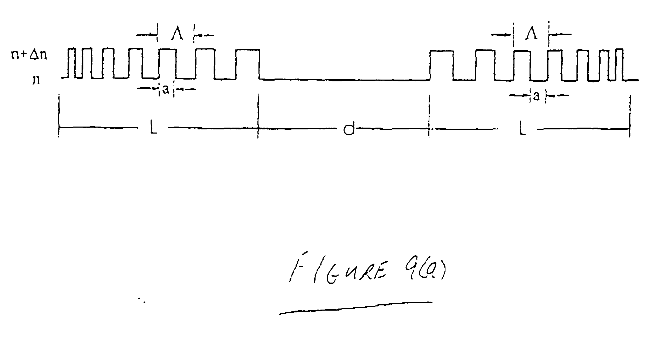

Optical fiber filters with different transmission spectra have been fabricated by varying the length of the phase gaps. Three masks were made with a period of 460 micrometer and a $L_1/L$ ratio of 0.2. For example, when the gap length equals to 17/36 of the grating period to give a phase gap of 217 μm, a 170° phase shift is introduced between the light transmitted through the two sections of the long-period grating separated by the phase gap. This design produces a shoulder on the lower wavelength portion of the main loss peak, see the spectrum in Figure 6(c). Similarly a phase gap length of 19/36 of the grating period, to give a phase gap of 243 μm, corresponds to a 190° phase shift, produces a shoulder on longer wavelength of the main loss peak, see the spectrum of Figure 6(b). When the gap length equals 230 μm, a 180° phase shift is produced, see the transmission spectrum of Figure 6(a). These results show that the transmission filters produced using these mask designs can be used to fabricate LPGs for gain flattening of the EDFA. However, it is preferred to have a phase shift for EDFA gain flattening of between 150° and 180°.

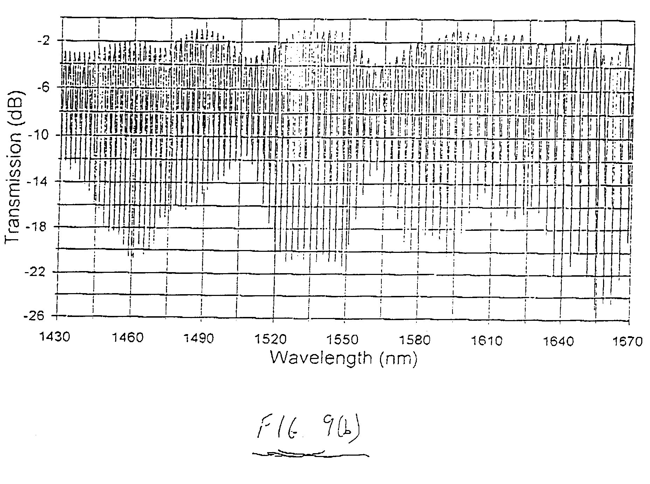

Another embodiment of a filter produced in accordance with the present invention that also produces a shoulder on the main loss peak is made using an amplitude mask in which the periodicity of the two sections 22 and 24 (Figure 1) of the long-period grating are different. For example, three amplitude masks were made with the period of the first sections being 460 $\mu$m, 464 $\mu$m and 468 $\mu$m respectively while the period of the second section for each mask was 464 $\mu$m. The length of the phase gap is kept at 232 micrometer and the $L_1/L$ ratio at 0.21. Figures 7(a), 7(b) and 7(c) show three transmission spectra of the LPGs made with these three masks with Figure 7(a) being the spectrum obtained with the mask with a periodicity of the first section being 460 $\mu$m, Figure 7(b) being the spectrum obtained with the mask periodicity of the first section being 464 $\mu$m, and Figure 7(c) being the spectrum obtained with the mask with a periodicity of the first section being 468 $\mu$m. The alignment of the laser beam and amplitude mask relative to the fiber is maintained the same during the process of writing in the grating. The mask with the periods of 460 $\mu$m and 464 $\mu$m for the first and second sections respectively generates a shoulder on the shorter wavelength side of the main loss peak (see Figure 7(a)), the mask with periods of 468 $\mu$m and 464 $\mu$m generates a shoulder on the longer wavelength side of the main loss peak (see Figure 7(c), and the mask with same periodicities for two sections (464 $\mu$m) generates two similar loss peaks (see Figure 7(b). Referring specifically to Figure 7(a) showing a shoulder on the shorter wavelength side, these results show that this mask design may be used to fabricate LPGs for gain flattening of EDFA. A gain-flattened erbium-doped fiber amplifier produced according to the present invention may incorporate the LPG anywhere from the middle to the end of the erbium doped fiber.

**EXAMPLE 2**

**Design And Fabrication Of Long-Period Fiber Gratings For A Fiber Notch Filter**

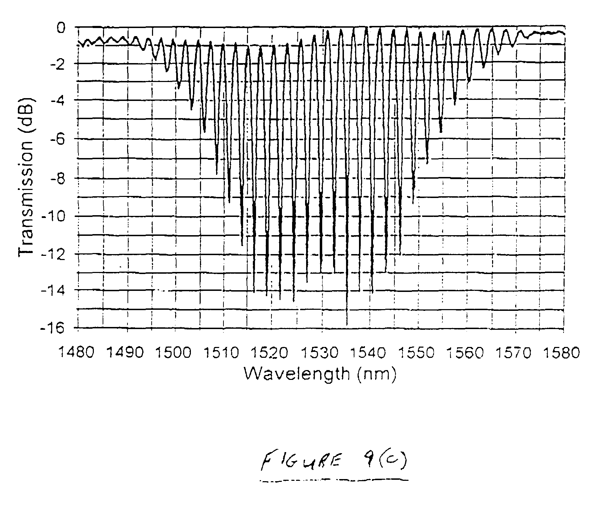

A notch filter can be very useful to suppress ASE and to reduce the $SiO_2$ band in fiber coupled Raman spectroscopy. A notch filter, having a broad bandwidth and a flat bottom, was made with an amplitude mask similar to the one shown in Figure 1 having a ratio $L_1 / L = 0.185$ and a phase gap $\Delta = 0.5\ \Lambda$, a period of 450 $\mu$m, and the width X of each aperture X=225 $\mu$m.
Referring to the spectrum shown in Figure 8, this filter suppresses 20 dB of transmitted light over a 6 nm band and 10 dB over a 20 nm band.

**EXAMPLE 3**

**Design And Fabrication of Chirped Cascaded Long-period Fiber Gratings For A Multi-Wavelength Isolation Filter**

Wavelength-division multiplexing (WDM) is becoming more important in optical fiber communication. In a WDM based system, high isolation loss between adjacent channels is required to ensure less interference from source instability and less cross-talk between neighboring channels. An isolation of 10-30 dB is usually adequate. A new design and fabrication method is described below for a novel WDM isolation fiber filter based on chirped cascaded long-period fiber gratings. Referring to Figure 9(a), two chirped cascaded LPGs, typically 1 to 1.5 cm long, separated by tens of centimeters, are made with normal single mode communication fibers. The irradiating time is controlled so that the power coupled into one cladding mode by the first LPG equals to the power of the core mode. The second LPG combines the two modes that results in sharp interference fringes. The chirp of LPG increases substantially the linewidth of the loss peak from that of non-chirped LPG. Since the fiber between those two LPGs causes a phase delay between the propagating cladding mode and core mode, the wavelength spacing and the linewidth of the loss peaks can be reduced by increasing the fiber length between the LPGs.
The transmission spectrum of such a device, comprising two 1 cm long chirped LPGs separated by 20 cm, is shown in Figure 9(b). The chirp of the grating is 100 $\mu$m/cm, i e. the period increases from 396 $\mu$m to 496 $\mu$m over 1 cm. More than 90 loss peaks appear in a 240 nm band as shown in Figure 9(b). The 3dB linewidth increases from 0.8 nm at 1430 nm to 1.84 nm at 1670 nm. The wavelength spacing of the loss peaks increases from 2 nm at 1430 to 3.6 nm at 1670 nm. If the chirp of the grating is reduced to zero, the multiple loss peaks will be equally spaced and their linewidth will be the same. However the overall band width of the multiple loss peaks will be reduced. Figure 9(c) shows a transmission spectrum for two cascaded non-chirped long-period gratings, each 1 cm in length with a spacing of 20 cm between the two gratings. The number of the loss peaks observed are limited by the linewidth of the edge emitting diode (ELED) used as a light source. The results of Figure 9(b) clearly demonstrate the utility of chirped cascaded LPGs disclosed herein for use in WDM channel isolation filters. Chirped cascaded long-period gratings have also been produced in which the first long-period grating is not chirped while a second LPG is chirped. Transmission spectra obtained were similar to the spectra shown in Figure 9(b) with both LPG being chirped (data not shown).

**EXAMPLE 4**

**Fiber Filter With Different Amplitude Index Of Refraction Modulation In Two Sections Of Long-Period Grating**

Non-symmetric transmission peaks were obtained by inserting a $2\pi$ phase gap between the first and second grating sections with the modulation of the index of refraction of the two sections being different (data not shown). The difference of modulation of the index of refraction was achieved by using a filter to vary the intensity of the laser beam illuminating the two sections of the optical fiber during the process of writing in the LPG.

In summary, methods of producing optical transmission fiber filters based on long-period gratings have been disclosed. Fiber filters exhibiting different transmission spectral shapes such as a Gaussian profile, a Gaussian with a shoulder on either shorter or longer wavelength side, a notch with a flat bottom and multiple loss peaks over a band broader than 240 nm are disclosed. The all-fiber filters disclosed herein exhibit low insertion losses, low back-reflection and can be packaged relatively easily. One can tailor complex loss shapes by varying the length and the position of the phase gap, the exposure time of the photosensitive fiber to the laser beam, the laser power density, and the relative position of laser beam with respect to the mask.

In all of the exemplary embodiments of this invention described heretofore, the protective buffer coating of the fiber about the long period gratings and within the gap between the long period gratings has been removed to reduce or eliminate the loss of light coupled out from the core to the cladding that would otherwise be lost to the buffer region.

The above-described examples will be understood to be non-limiting examples only to illustrate the invention. Those skilled in the art will readily understand how to produce gratings for different applications based on the principles disclosed herein and defined by the claims.

**Claims**

1. A method of making an optical waveguide filter, comprising the steps of:

    providing a dielectric optical waveguide having at least a core, cladding and a photosensitive longitudinal portion;
    providing an amplitude mask having at least two sections therein, said at least two sections being spaced by a preselected phase gap, the preselected phase gap being selected to provide a desired output response of the optical waveguide filter;
    and irradiating the dielectric optical waveguide through the amplitude mask for a time sufficient to effect a long-period grating within said core, the long-period grating within the core including at least two grating sections directly corresponding to the at least two sections within the mask, the long period grating within the core having the preselected phase gap $\Delta$ between the at least two grating sections.

2. A method as defined in claim 1, wherein a first grating section has a first modulated index of refraction and a first grating section periodicity and wherein a second grating section has a second modulated index of refraction and a second grating section periodicity, and wherein the preselected phase gap $\Delta = G$ or $G + n\pi$, $0.8\pi < G < \pi$ and where n is an even number.

3. A method as defined in claim 2, wherein the optical waveguide is an optical fibre, and further including the step of at least partially removing at least a portion of a buffer of the optical fibre between the first and second grating sections.

4. A method as defined in claim 1, wherein the optical waveguide filter is for flattening the gain spectrum of an optical amplifier and wherein the phase gap $\Delta = G$ or $G + n\pi$, $0 < G < \pi$ and where n is an even number.

5. A method as defined in claim 1 wherein the periodicity $\Lambda$ of the first and second grating sections is in the range from about 10 $\mu$m to about 2000 $\mu$m.

6. The optical fiber filter fabricated according to the method of claim 2 wherein said preselected gap has a length of $\Delta$, wherein said at least first and second grating sections have substantially equal periodicities given by $\Lambda$, and wherein $\Delta \leq \Lambda$.

7. An optical fiber filter fabricated according to the method of claim 1 wherein said at least two grating sections include three or more grating sections with a preselected phase gap between each grating section, and wherein the grating section periodicity of each grating section is in the range from about 10 $\mu$m to about 2000 $\mu$m.

8. An optical fiber filter for gain flattening an erbium doped fibre amplifier, comprising:

    an optical fiber including a long-period fiber grating having a length L and a periodicity $\Lambda$, said long-period grating including first and second grating sections, said second grating section being spaced from said first grating section by a preselected gap $\Delta$ for obtaining a gain flattening output response, wherein $\Delta = G$ or $G + n\pi$, $0 < G < \pi$ and where n is an even number.

9. The optical fiber filter for gain flattening an optical amplifier according to claim 8 wherein $0.8\pi < G < \pi$.

10. The optical fiber filter according to claim 8 wherein a portion of the optical fibre defining the preselected phase gap is absent at least a portion of a buffer coating a portion of the fibre about the gratings.

11. An optical fiber filter for gain flattening of an erbium-doped fiber amplifier, comprising:

an optical fiber including a long-period fiber grating of length L having a grating periodicity $\Lambda$ in a range 10 $\mu$m $\leq \Lambda \leq$ 2000 $\mu$m, said long-period grating including at least a first grating section of length $L_1$, wherein $L_1/L \leq 0.5$, and a second grating section spaced from said first grating section by a preselected gap of length $\Delta$ to obtain a predetermined output response, wherein $\Delta < \Lambda$.

12. A multi-wavelength isolation filter, comprising:

an optical fiber including a core and at least two long-period gratings in said core, at least one of said at least two long-period gratings being chirped, said at least two long-period gratings being spaced apart by a preselected distance.

13. A method of producing an optical fiber filter with a preselected transmission spectrum, comprising:

providing an optical fiber having a core and a cladding and a photosensitive longitudinal portion;
computing a phase gap that is to be provided in an amplitude mask between at least two grating sections;
providing the amplitude mask including at least two longitudinal sections, a first of said longitudinal sections and a second longitudinal section being spaced from said first longitudinal section by the computed phase gap, wherein the spaced first and second longitudinal sections are for providing a grating having a periodicity $\Lambda$ in a range of about 10 $\mu$m $\leq \Lambda \leq$ 2000 $\mu$m; and,
aligning said amplitude mask with said photosensitive portion of said optical fiber and irradiating the photosensitive portion through said first and second longitudinal sections of said mask with a light source to produce a long-period grating directly corresponding to the first longitudinal section, the second longitudinal section and the computed phase gap.

FIGURE 3

Figure 1

Figure 2

EP 0 897 124 A1

FIG 4a

FIG 4b

FIG. 4c

FIG. 4d

FIGURE 5 (a)

FIGURE 5 (b)

(a)

FIG. 6(a)

(b)

FIG. 6(b)

(c)

FIG. 6(c)

FIG. 7(a)

FIG. 7(b)

FIG. 7(c)

FIG. 8

FIGURE 9(a)

FIG 9(b)

FIGURE 9(c)

**European Patent Office**

## EUROPEAN SEARCH REPORT

Application Number

EP 98 20 2691

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int.Cl.6) |
| A | LEGOUBIN S ET AL: "FREE SPECTRAL RANGE VARIATIONS OF GRATING-BASED FABRY-PEROT FILTERS PHOTOWRITTEN IN OPTICAL FIBERS" JOURNAL OF THE OPTICAL SOCIETY OF AMERICA - A, vol. 12, no. 8, 1 August 1995, pages 1687-1694, XP000606143 * the whole document * --- | 1,3,13 | G02B6/293 G02B6/124 G02B6/34 H01S3/06 H01S3/085 |
| A | OKAI M ET AL: "IN-LINE FABRY-PEROT OPTICAL WAVEGUIDE FILTER WITH QUASI-CHIRPED GRATINGS" ELECTRONICS LETTERS, vol. 32, no. 2, 18 January 1996, page 108/109 XP000553407 * the whole document * --- | 1,12,13 | |
| A | EP 0 785 600 A (LUCENT TECHNOLOGIES INC) 23 July 1997 * column 2, line 35 - line 58 * * column 3, line 1 - line 58 * * column 4, line 1 - line 30 * * figures 1,3A,3A * --- | 1,3,7,8, 11 | |
| A | WO 96 24079 A (UNIV SYDNEY ;OUELLETTE FRANCOIS (AU); EGGLETON BEN (AU); KRUG PETE) 8 August 1996 * figures 1-7 * * page 8, line 31 - line 38 * * page 9 - page 11 * * page 12, line 1 - line 29 * --- | 1,3,13 | TECHNICAL FIELDS SEARCHED (Int.Cl.6) G02B H01S |
| A | US 5 434 702 A (BYRON KEVIN C) 18 July 1995 * the whole document * ----- | 1,8,11 | |

The present search report has been drawn up for all claims

| Place of search | Date of completion of the search | Examiner |
|---|---|---|
| THE HAGUE | 25 November 1998 | Mathyssek, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)